# EUROPÄISCHE PATENTSCHRIFT

(11) **EP 3 665 314 B1**
(45) Veröffentlichungstag und Bekanntmachung des Hinweises auf die Patenterteilung: **19.05.2021**
(21) Anmeldenummer: 18733792.8
(22) Anmeldetag: 11.06.2018
(51) Int. Cl.: C23C 14/06, C25B 9/04, H01M 8/021, H01M 8/0228, H01M 8/1018

(54) **BESCHICHTUNG UND SCHICHTSYSTEM, SOWIE BIPOLARPLATTE, BRENNSTOFFZELLE UND ELEKTROLYSEUR**
COATING AND LAYER SYSTEM, AND BIPOLAR PLATE, FUEL CELL AND ELECTROLYSER
REVÊTEMENT ET SYSTÈME DE COUCHES, AINSI QUE PLAQUE BIPOLAIRE, PILE À COMBUSTIBLE ET ÉLECTROLYSEUR

(30) Priorität: 11.08.2017 DE 102017118319
(43) Veröffentlichungstag der Anmeldung: 17.06.2020
(73) Patentinhaber: Schaeffler Technologies AG & Co. KG, 91074 Herzogenaurach (DE)
(72) Erfinder: DOBRENIZKI, Ladislaus, 90453 Nürnberg (DE); MUSAYEV, Yashar, 90425 Nürnberg (DE); HOSENFELDT, Tim, 90480 Nürnberg (DE); REPENNING, Detlev, 21465 Krabbenhöhe (DE)
(86) Internationale Anmeldenummer: PCT/DE2018/100551
(87) Internationale Veröffentlichungsnummer: WO 2019/029762

(56) Entgegenhaltungen:
- WO-A1-2017/140293
- CN-A- 1 772 664
- DE-A1-102010 022 231

## Beschreibung

Die Erfindung betrifft eine Beschichtung, insbesondere für eine Bipolarplatte einer Brennstoffzelle oder eines Elektrolyseurs. Des Weiteren betrifft die Erfindung ein Schichtsystem mit einer derartigen Beschichtung sowie eine Bipolarplatte mit einem derartigen Schichtsystem. Die Erfindung betrifft weiterhin eine Brennstoffzelle oder einen Elektrolyseur mit einer solchen Bipolarplatte.

Elektrochemische Systeme wie bspw. Brennstoffzellen, insbesondere Polymerelektrolytbrennstoffzellen, und leitfähige, stromabnehmende Platten für derartige Brennstoffzellen und Elektrolyseure sowie Stromabnehmer in galvanischen Zellen und Elektrolyseuren sind bekannt.

Ein Beispiel hierfür sind die Bipolar- oder Monopolarplatten in Brennstoffzellen, insbesondere in einer Sauerstoffhalbzelle. Die Bipolar- oder Monopolarplatten sind in Form von Kohlenstoffplatten (z.B. Graphoilplatten) ausgebildet, die als wesentlichen Bestandteil Kohlenstoff enthalten. Diese Platten neigen zur Brüchigkeit und sind vergleichsweise dick, sodass sie ein Leistungsvolumen der Brennstoffzelle wesentlich mindern. Ein weiterer Nachteil ist ihre mangelnde physikalische (z.B. thermomechanische) und/oder chemische und/oder elektrische Stabilität.

Ebenso bekannt ist die Herstellung der stromabnehmenden Platten der Brennstoffzelle aus metallischen (insbesondere austenitischen) Edelstählen. Der Vorteil dieser Platten liegt in einer erzielbaren Dicke der Platten von weniger als 0,5 mm. Diese Dicke ist anzustreben, damit sowohl ein Bauraum als auch ein Gewicht der Brennstoffzelle so gering wie möglich gehalten werden kann. Problematisch ist bei diesen Platten, dass Oberflächenoxide bei Betrieb der Brennstoffzelle gebildet werden, sodass ein Oberflächenwiderstand unzulässig erhöht wird und/oder ein elektrochemischer Zerfall (wie beispielsweise Korrosion) eintritt.

Aus den Offenlegungsschriften DE 10 2010 026 330 A1, DE 10 2013 209 918 A1, DE 11 2005 001 704 T5 und DE 11 2008 003 275 T5 geht zur Erzielung der Anforderung z.B. für den Einsatz von Bipolarplatten von Brennstoffzellen die Beschichtung von austenitischen Edelstählen als Träger mit einer Goldschicht hervor, welche in einem Bandbereich von bis zu 2 nm liegt. Dieser Anforderungslösung obliegen gleich mehrere Nachteile. So ist beispielsweise eine, wenn auch nur 2 nm dicke Goldschicht für Massenanwendungen immer noch zu teuer. Ein wesentlich größerer Nachteil ist in einer Grundeigenschaft des chemischen Elementes Gold zu sehen. Gold ist edler als das Trägermaterial als nicht rostender austenitischer Stahl (Edelstahl) und erwirkt dadurch unter ungünstigen Betriebsbedingungen in den Brennstoffzellen eine Auflösung des Trägers (z.B. Lochfraß- bzw. Pittingkorrosion), die eine Reduzierung der Lebensdauer zur Folge hat. In insbesondere chloridhaltiger Umgebung (z.B. Aerosolen) ist die Korrosion nicht zu verhindern.

Insbesondere ist ein weiterer Nachteil, dass Gold für Hochlastanwendungen z.B. bei Elektrolysebedingungen oberhalb 1500 mV Standardwasserstoffeinheit sowohl in saurer als auch basischer Umgebung nicht stabil ist.

Aus dem Stand der Technik bekannt sind ebenso Schichten auf dem Träger in Form so genannter Hartstoffschichten auf Nitrid- bzw. Carbidbasis. Ein Beispiel hierfür ist Titannitrid, das allerdings im Betrieb einer Brennstoffzelle zur Ausbildung oxidischer Metallkomplexe bis hin zu geschlossenen Oberflächenschichten neigt. Infolgedessen steigt der Oberflächenwiderstand wie auch beim Edelstahl auf hohe Werte. Verfahren zur Beschichtung mit Chromnitrid oder Chromcarbonitrid gehen beispielsweise aus den Patentschriften DE 199 37 255 B4 und EP 1273060 B1 und der Offenlegungsschrift DE 100 17 200 A1 hervor.

Die Hartstoffschichten weisen je nach Zusammensetzung sehr gute Betriebseigenschaften (bspw. Widerstand gegen Korrosion, Abriebfestigkeit, hohe Konturtreue) auf, bergen jedoch das Risiko zur anodischen Auflösung, wenn sich unter ungünstigen Betriebsbedingungen in der Brennstoffzelle Konzentrationsketten ausbilden. Diese anodische Auflösung tritt dann in Erscheinung, wenn bei inneren elektrochemischen Kurzschlüssen in der Brennstoffzelle, wie z.B. bei der Ausbildung eines Wasserfilmes zwischen einer aktiven Elektrode einer Membran-Elektroden-Einheit der Brennstoffzelle und der Bipolarplatte ein so genanntes Lokalelement bzw. ein unerwartetes und unerwünschtes Reaktionselement entsteht.

Ebenfalls bekannt sind Mehrfachbeschichtungen auf Basis von Nitriden mit sehr dünnen Gold- oder Platinschichten. Somit können bei Schichtdicken der Edelmetalle von über 2 µm zufriedenstellende Betriebsergebnisse für eine Brennstoffzelle erzielt werden. Das grundlegende Problem der Auflösung bleibt bei hohen anodischen Potenzialen bestehen. Die Schichtdicke gewährleistet eine nahezu porenfreie Decklage und mindert somit das Risiko der Pittingkorrosion.

Weiterhin sind so genannte dimensionsstabile Anoden bekannt. Hier werden mit Hilfe von Refraktärmetallen einphasige oder mehrphasige Oxide mit Rutheniumoxid und/oder Iridiumoxid gebildet. Diese Art der Schicht ist zwar sehr stabil, bildet aber zu hohe elektrische Widerstände aus. Entsprechendes liegt auch vor, wenn eine Oberfläche des Trägers, im Allgemeinen aus einem Edelmetall hergestellt, mit Iridium dotiert wird.

Die DE 10 2010 022 231 A1 offenbart eine bipolare Platte umfassend ein Substrat aus rostfreiem Stahl sowie eine Kohlenstoff enthaltende Schicht, welche mit einem Metall dotiert ist. Das Metall ist aus der Gruppe umfassend Platin, Iridium, Ruthenium, Gold, Palladium und Mischungen davon ausgewählt.

Somit sind an die in diesen beispielhaft genannten elektrochemischen Systemen, insbesondere zur Energiewandlung, ausgebildeten metallischen Träger bzw. eine Bipolarplatte für eine PEM-Brennstoffzelle oder einen Elektrolyseur folgende Anforderungen zu stellen:
- Hohe Korrosionsfestigkeit gegenüber ein sie umgebendes Medium, und/oder
- hohe Belastbarkeit gegenüber anodischen bzw. kathodisch polarisierenden Belastungen,
- geringer Oberflächenwiderstand einer einem Elektrolyten zugewandten Oberfläche des Trägers bzw. seiner Beschichtung, und
- niedrige Produktionskosten des Trägers, insbesondere bspw. eines elektrisch leitenden Konduktors in Form von Bipolarplatten für die Anwendung von Brennstoffzellen für mobile und stationäre Einsatzzwecke.

Somit ist es die Aufgabe der vorliegenden Erfindung eine verbesserte Beschichtung bzw. ein verbessertes Schichtsystem ganz allgemein für einen Energiewandler, insbesondere für eine Bipolarplatte einer Brennstoffzelle oder eines Elektrolyseurs, bereitzustellen. Des Weiteren ist es die Aufgabe der Erfindung, eine Bipolarplatte mit einem verbesserten Schichtsystem und eine damit ausgestattete Brennstoffzelle und einen damit ausgestatteten Elektrolyseur anzugeben.

Die Aufgabe wird erfindungsgemäß durch eine Beschichtung, insbesondere für eine Bipolarplatte einer Brennstoffzelle oder eines Elektrolyseurs, gelöst, wobei die Beschichtung aus einer homogenen oder heterogenen festen metallischen Lösung besteht, die entweder ein erstes chemisches Element aus der Gruppe der Edelmetalle in Form von Iridium in einer Konzentration von mindestens 99 At.-% enthält oder ein erstes chemisches Element aus der Gruppe der Edelmetalle in Form von Iridium und ein zweites chemisches Element aus der Gruppe der Edelmetalle in Form von Ruthenium enthält, wobei das erste chemische Element und das zweite chemische Element insgesamt in einer Konzentration von mindestens 99 At.-% vorhanden sind,
sowie weiterhin zumindest ein weiteres nichtmetallisches chemisches Element enthält aus der Gruppe umfassend Stickstoff, Kohlenstoff, Fluor, wobei das mindestens eine nichtmetallische chemische Element in einer Konzentration im Bereich von 0,1 At.-% bis 1 At.-% in der Beschichtung vorhanden ist und wobei weiterhin Sauerstoff und Wasserstoff lediglich in Spuren vorhanden sind.

Die Aufgabe wird weiterhin erfindungsgemäß durch ein Schichtsystem, insbesondere für eine Bipolarplatte einer Brennstoffzelle oder eines Elektrolyseurs, umfassend eine Deckschicht und ein Unterlagenschichtsystem gelöst, indem die Deckschicht in Form der erfindungsgemäßen Beschichtung ausgebildet ist.

Die Aufgabe wird weiterhin erfindungsgemäß durch eine Bipolarplatte umfassend ein Substrat und das zumindest in Teilbereichen einer Oberfläche des Substrats aufgebrachtes erfindungsgemäßes Schichtsystem gelöst.

Die Aufgabe wird weiterhin erfindungsgemäß durch eine Brennstoffzelle, insbesondere Polymerelektrolytbrennstoffzelle, umfassend mindestens eine erfindungsgemäße Bipolarplatte gelöst.

Die Aufgabe wird weiterhin erfindungsgemäß durch einen Elektrolyseur umfassend mindestens eine erfindungsgemäße Bipolarplatte gelöst.

Vorteilhafte Ausgestaltungen mit zweckmäßigen und nicht-trivialen Weiterbildungen der Erfindung sind in den Unteransprüchen angegeben.

Die erfindungsgemäße Beschichtung ist elektrisch leitend und elektrokatalytisch aktiv sowie korrosionsschützend ausgebildet.

Unter einer homogenen metallischen Lösung (Typ 1) wird verstanden, dass die genannten nichtmetallischen chemischen Elemente im Metallgitter so gelöst sind, dass sich der Gittertyp des Wirtsmetalls oder der Wirtsmetalllegierung im Wesentlichen nicht ändert.

Unter einer heterogenen metallischen Lösung wird verstanden, dass neben der metallhaltigen Phase auch eines der nichtmetallischen chemischen Elemente in einer Mischphase elementar vorliegt. Beispielweise kann so je nach Ausprägung des Phasendiagramms elementarer Kohlenstoff neben der alpha-Phase (Typ 1) vorliegen.

Je nach Abscheidebedingungen kann die erfindungsgemäße Schicht im thermodynamischen Sinn metastabil oder stabil sein.

Es hat sich gezeigt, dass mit einer kohlenstoffhaltigen Schicht, somit durch den Einsatz des Metalloids bzw. nichtmetallischen chemischen Elements Kohlenstoff, die Leitfähigkeit der Schicht höher ist als bei Gold und dass zugleich ihre Oxidationsstabilität in einer sauren Lösung deutlich über einer Spannung von 2000 mV einer Standardwasserstoffelektrode liegt. Gemessene spezifische elektrische Widerstände sind je nach Ausführungsform vergleichbar mit Gold (unter standardisierten Bedingungen, d.h. bei einer Andruckkraft von 140 N/cm²). Der spezifische elektrische Widerstand von Gold liegt bei ca. 10 mΩ cm⁻² bei Raumtemperatur (T = 20°C).

Ein weiterer wichtiger Vorteil ist, dass das Iridium nicht bei Spannungen oberhalb des Wertes E = 2,04 - 0,059 lg pH- -0,0295 lg (IrO₄)²⁻ oxidiert und in Lösung geht. In der festen Lösung wird also das niederwertige Iridium soweit stabilisiert, dass die sonst übliche Oxidation bei ca. 1800 mV in 1 mol/l (1N-konzentrierter) Schwefelsäure (H₂SO₄) nicht mehr stattfindet. Maßgabe für die Stabilisierung ist der Gewinn an freier partieller Mischenergie ΔG_{Misch} der festen Lösungen bzw. Verbindungen.

Die erfindungsgemäße Beschichtung weist bevorzugt eine Schichtdicke von mindestens 1 nm bis maximal 10 nm auf.

Beispielsweise ergeben sich bei einer Schichtdicke von ca. 10 nm bei einer Verwendung von Irₓ -C₁₋ₓ nur 4 µg Iridium pro cm² der Schicht. Für eine 10 nm dicke Goldschicht müssen mehr als 20 µg Gold pro cm² eingesetzt werden. Der Vorteil der erfindungsgemäßen Beschichtung im Vergleich zu einer Goldschicht ist die hohe Oxidationsstabilität bis zu Spannungen weit oberhalb 2000 mV gegenüber einer Standardwasserstoffelektrode in 1N-konzentrierter Schwefelsäure.

Mit einer erfindungsgemäßen Beschichtung ist die Stabilität von beispielsweise Iridium-haltigen dimensionsstabilen Anoden-Elektroden deutlich zu steigern.

Das mindestens eine nichtmetallische chemische Element, also Kohlenstoff und/oder Stickstoff und/oder Fluor, ist in einer Konzentration im Bereich von 0,1 At.-% bis 1 At.-% in der Beschichtung vorhanden. Insbesondere ist das nichtmetallische chemische Element Kohlenstoff im Konzentrationsbereich von 0,10 bis 1 At.-% in der Beschichtung enthalten. Insbesondere ist das nichtmetallische chemische Element Stickstoff im Konzentrationsbereich von 0,10 bis 1 At.-% in der Beschichtung enthalten. Insbesondere ist das nichtmetallische chemische Element Fluor im Konzentrationsbereich bis maximal 0,5 At.-% in der Beschichtung enthalten.

Insbesondere hat sich eine erfindungsgemäße Schicht bewährt, die
a) mindestens 99 At.-% Iridium und weiterhin Kohlenstoff und in Spuren Sauerstoff und Wasserstoff umfasst; oder
b) mindestens 99 At.-% Iridium und weiterhin Kohlenstoff und Fluor, sowie weiterhin in Spuren Sauerstoff und Wasserstoff, umfasst; oder
c) in Summe mindestens 15 bis 98,9 At.-% Iridium und 0,1 bis 84 At.-% Ruthenium und weiterhin Kohlenstoff und in Spuren Sauerstoff und Wasserstoff umfasst; oder
d) in Summe mindestens 15 bis 98,9 At.-% Iridium und 0,1 bis 84 At.-% Ruthenium und weiterhin Kohlenstoff und Fluor, sowie weiterhin in Spuren Sauerstoff und Wasserstoff, umfasst.

Weiterhin kann die erfindungsgemäße Beschichtung mindestens ein chemisches Element aus der Gruppe der unedlen Metalle enthalten. Das mindestens eine chemische Element aus der Gruppe der unedlen Metalle ist dabei bevorzugt durch Aluminium, Eisen, Nickel, Kobalt, Zink, Cer oder Zinn gebildet und/oder im Konzentrationsbereich von 0,005 bis 0,01 At.-% in der Beschichtung enthalten.

In einer weiteren vorteilhaften Ausgestaltung der erfindungsgemäßen Beschichtung weist diese zumindest ein chemisches Element aus der Gruppe der Refraktärmetalle, insbesondere Titan und/oder Zirkonium und/oder Hafnium und/oder Niob und/oder Tantal, auf. Es hat sich gezeigt, dass durch den Zusatz der Refraktärmetalle zusätzlich anteilsweise während der Elektrolyse entstehendes H₂O₂ und Ozon gesteuert werden. Ein weiterer Vorteil bei Nutzung dieser Metalle - entweder elementar oder in Form von Verbindungen - liegt darin, dass sie unter Korrosionsbedingungen selbstschützende, stabile und leitfähige Oxide ausbilden.

Die erfindungsgemäße Schicht, umfassend mindestens ein Refraktärmetall, weist insbesondere in einem Temperaturbereich von 0 bis ca. 200 °C eine hohe Leitfähigkeit und eine hohe Korrosionsbeständigkeit auf. Somit sind herausragende Eigenschaften für einen dauerfesten Einsatz in z. B. Brennstoffzellen hergestellt.

Ein weiterer Vorteil ergibt sich aus der Beschichtung von elektrischen Konduktoren, wie insbesondere metallischen Bipolarplatten, unabhängig davon, ob der elektrische Konduktor wie z.B. eine Bipolarplatte für Niedertemperatur-Polymerelektrolytbrennstoffzellen oder für Hochtemperatur-Polymerelektrolytbrennstoffzellen ausgebildet ist. Der besondere Vorteil liegt darin, dass die erfindungsgemäße Beschichtung mit einer Dichte zwischen 10-13 gcm⁻³ eine fast nur halb so hohe Dichte aufweist im Vergleich zu einem reinen Edelmetall. Somit kann der Einsatz teurer Edelmetalle und/oder seiner Verbindungen reduziert werden.

Das mindestens eine chemische Element aus der Gruppe der Refraktärmetalle ist bevorzugt im Konzentrationsbereich von 0,005 bis 0,01 At.-% in der Schicht enthalten.

Sofern das mindestens eine chemische Element aus der Gruppe der unedlen Metalle in Form von Zinn vorliegt, so sind dieses und das mindestens eine chemische Element aus der Gruppe der Refraktärmetalle zusammen im Konzentrationsbereich von 0,01 bis 0,2 At.-% in der Schicht enthalten.

Es hat sich bewährt, wenn die erfindungsgemäße Schicht weiterhin mindestens ein zusätzliches chemisches Element aus der Gruppe der Edelmetalle in einem Konzentrationsbereich von 0,005 bis 0,9 At.-% aufweist. Das chemische Element aus der Gruppe der Edelmetalle ist insbesondere Platin, Gold, Silber, Rhodium, Palladium.

Es hat sich bewährt, wenn alle chemischen Elemente aus der Gruppe der Edelmetalle, d.h. zusammen mit Iridium und Ruthenium, im Konzentrationsbereich von größer 99 At.-% in der Schicht enthalten sind.

Der Korrosionsschutz auf metallischen Trägern, wie aus Stählen, insbesondere Edelstählen, oder Titan, wird dadurch weiter verbessert, indem die erfindungsgemäße Beschichtung auf ein zwischen dem Träger und der Beschichtung ausgebildetes Unterschichtsystem aufgebracht wird. Dieses ist besonders dann von Vorteil, wenn korrosive Umgebungsmedien vorhanden sind, insbesondere wenn die Korrosionsmedien chloridhaltig sind.

Eine Unteroxidation, d.h. eine Oxidation der Oberfläche eines Trägers mit einer auf dieser Oberfläche aufgebrachten Beschichtung, führt normalerweise zur Delamination aufliegender Edelmetallschichten.

Das erfindungsgemäße Schichtsystem, insbesondere für eine Bipolarplatte einer Brennstoffzelle oder eines Elektrolyseurs, umfasst daher eine Deckschicht und ein Unterlagenschichtsystem, wobei die Deckschicht in Form der erfindungsgemäßen Beschichtung ausgebildet ist.

Insbesondere umfasst das Unterlagenschichtsystem mindestens eine Unterlagenschicht, die mindestens ein chemisches Element aufweist aus der Gruppe Titan, Niob, Hafnium, Zirkonium, Tantal.

Das Unterlagenschichtsystem weist insbesondere eine erste Unterlagenschicht in Form einer metallischen Legierungsschicht auf umfassend die chemischen Elemente Titan und Niob, insbesondere 20 - 50 Gew.-% Niob und Rest Titan.

Das Unterlagenschichtsystem weist insbesondere eine zweite Unterlagenschicht auf umfassend mindestens ein chemisches Element aus der Gruppe Titan, Niob, Zirkonium, Hafnium, Tantal und weiterhin mindestens ein nichtmetallisches Element aus der Gruppe Stickstoff, Kohlenstoff, Bor, Fluor.

Das Unterlagenschichtsystem weist in einer besonders bevorzugten Ausführungsform eine zweite Unterlagenschicht umfassend die chemischen Elemente
a) Titan, Niob und weiterhin Kohlenstoff und Fluor auf, oder
b) Titan, Niob und weiterhin Stickstoff auf, ist insbesondere aus (Ti_{0,67}Nb_{0,33})₁₋ₓNₓ mit x= 0,40 - 0,55 gebildet.

Dabei wird das Material unter der Bezeichnung (Ti_{0,67}Nb_{0,33})₁₋ₓNₓ mit x= 0,40 - 0,55 derart gebildet, dass die zweite Unterlagenschicht durch Zerstäubung eines Targets aus Ti_{0,67}Nb_{0,33} erzeugt wird, wobei in die zweite Unterlagenschicht Stickstoff aus der Gasphase in einer Konzentration von 40 bis 55 At.-% eingelagert wird.

Die zweite Unterlagenschicht ist bevorzugt zwischen der ersten Unterlagenschicht und der Deckschicht angeordnet.

Die zweite Unterlagenschicht kann weiterhin bis zu 5 At.-% Sauerstoff enthalten.

Die erfindungsgemäße Bipolarplatte umfasst ein metallisches Substrat und ein zumindest in Teilbereichen der Oberfläche des Substrats aufgebrachtes erfindungsgemäßes Schichtsystem. Insbesondere ist das Schichtsystem auf einer oder beiden Seiten des plattenförmigen Substrats vollflächig aufgebracht. Das metallische Substrat ist insbesondere aus Stahl oder Titan, bevorzugt aus Edelstahl, gebildet. Eine Dicke des Substrats beträgt bevorzugt weniger als 1 mm und ist insbesondere gleich 0,5 mm.

Eine erfindungsgemäße Brennstoffzelle, insbesondere eine Polymerelektrolytbrennstoffzelle, umfassend mindestens eine erfindungsgemäße Bipolarplatte, hat sich als besonders vorteilhaft hinsichtlich der elektrischen Werte und der Korrosionsbeständigkeit erwiesen. Insbesondere lassen sich Oxidationsstabilitäten bei 2000 mV, gemessen als Veränderung des Oberflächenwiderstandes in mΩ cm⁻², von kleiner als 20 mΩ cm⁻² erreichen. Eine solche Brennstoffzelle weist daher eine hohe Lebensdauer von mehr als 10 Jahren oder mehr als 5000 Kfz-Betriebsstunden bzw. mehr als 60000 Betriebsstunden in stationären Anwendungen auf.

Mit einem erfindungsgemäßen Elektrolyseur, der mit umgekehrtem Wirkprinzip im Hinblick auf eine Brennstoffzelle arbeitet und mit Hilfe elektrischen Stroms eine chemische Reaktion, also eine Stoffumwandlung, herbeiführt, sind vergleichbar hohe Lebensdauern erreichbar. Insbesondere handelt es sich bei dem Elektrolyseur um einen zur Wasserstoffelektrolyse geeigneten.

Vorteilhafterweise ist eine Dicke der erfindungsgemäßen Beschichtung von weniger als 10 nm ausreichend, um vor einer widerstandserhöhenden Oxidation der zweiten Unterlagenschicht zu schützen. Zur Ausbildung eines gesicherten Korrosionsschutzes, sind Teilschichten des Unterlagenschichtsystems aus zumindest einem Refraktärmetall ausgebildet, welche zumindest zweilagig auf dem Stahl, insbesondere Edelstahl, appliziert sind, und zwar zunächst als Metall- bzw. Legierungsschicht (= erste Unterlagenschicht) und dann als Metalloidschicht (= zweite Unterlagenschicht). Die mit Hilfe der Zweilagigkeit ausgebildete Doppelschicht unter der erfindungsgemäßen Beschichtung sorgt einerseits für eine elektrochemische Anpassung an ein Trägermaterial, also das Material, aus welchem der Träger ausgebildet ist, und andererseits wird Porenbildung auf Grund von Oxidations- und Hydrolyseprozessen ausgeschlossen.

Die elektrochemische Anpassung an das Trägermaterial ist notwendig, da sowohl die Metalloidschicht (= zweite Unterlagenschicht) als auch die erfindungsgemäße Beschichtung bzw. die Deckschicht, sehr edel sind. Bei Porenbildung würden sich hohe Lokalelementpotentiale mit der Folge unzulässiger Korrosionsströme aufbauen. Die metallische erste Unterlagenschicht ist aus vorzugsweise Titan oder Niob oder Zirkonium oder Tantal oder Hafnium oder aus Legierungen dieser Metalle gebildet, die unedler sind als das Trägermaterial in Form von Stahl, insbesondere Edelstahl, und reagieren zunächst bei Korrosionsvorgängen zu nicht löslichen Oxiden bzw. voluminösen teils gelartigen Hydroxoverbindungen dieser Refraktärmetalle. Hierdurch wachsen die Poren zu und schützen das Grundmaterial vor Korrosion. Der Vorgang stellt eine Selbstheilung des Schichtsystems dar.

Insbesondere eine zweite Unterlagenschicht in Form einer nitridischen Schicht dient als Wasserstoffbarriere und schützt somit das Substrat, insbesondere aus Edelstahl, der Bipolarplatte als auch die metallische erste Unterlagenschicht vor einer Wasserstoffversprödung.

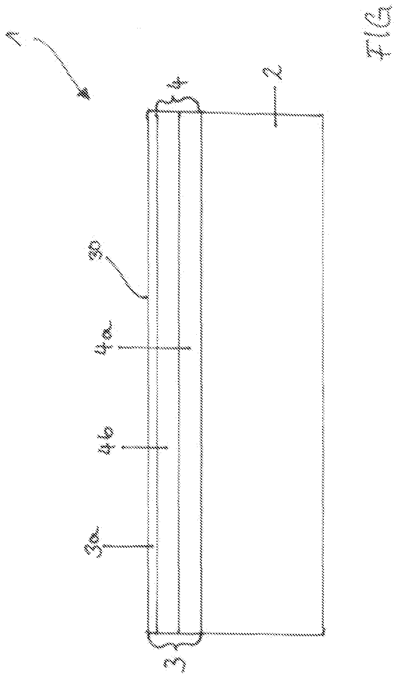

Weitere Vorteile, Merkmale und Einzelheiten der Erfindung ergeben sich aus der nachfolgenden Beschreibung bevorzugter Ausführungsbeispiele und der Figur. Die vorstehend in der Beschreibung genannten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Die Figur zeigt eine Bipolarplatte 1 umfassend ein Substrat 2 aus Edelstahl und ein vollflächig auf einer Seite des Substrats 2 aufgebrachtes Schichtsystem 3. Das Schichtsystem 2 umfasst eine Deckschicht 3a und ein Unterlagenschichtsystem 4 umfassend eine erste Unterlagenschicht 4a und eine zweite Unterlagenschicht 4b.

In einem ersten Ausführungsbeispiel ist ein metallisches Substrat 2 in Form eines Konduktors, hier für eine Bipolarplatte 1 einer Polymerelektrolytbrennstoffzelle zur Umsetzung von (reformiertem) Wasserstoff, aus einem Edelstahl, insbesondere aus einem so genannten authentischen Stahl mit sehr hoher bekannter Anforderung bzgl. Korrosionsbeständigkeit, z.B. mit der DIN ISO Werkstoffnummer 1.4404, hergestellt.

Mittels eines Beschichtungsverfahrens, beispielsweise einem vakuumbasierten Beschichtungsverfahrens (PVD), wird ein erfindungsgemäßes Schichtsystem 3 auf dem Substrat 2 der Bipolarplatte 1 ausgebildet, wobei das Substrat 2 in einem Verfahrensdurchgang zunächst mit einer ersten Unterlagenschicht 4a in Form einer 0,5 µm dicken Titanschicht, anschließend mit einer 1 µm dicken zweiten Unterlagenschicht 4b in Form einer Titannitridschicht und abschließend mit einer Deckschicht 3a in Form einer 10 nm dicken Iridium-Kohlenstoff-Schicht beschichtet wird. Die Deckschicht 3a entspricht einer einseitig offenen Schichtlage, da nur eine Deckschichtfläche einer weiteren Schicht, hier der zweiten Unterlagenschicht 4b, diese kontaktierend ausgebildet ist. Somit ist die freie Oberfläche 30 der Deckschicht 3a in einer Brennstoffzelle einem Elektrolyten, insbesondere einem Polymerelektrolyten, unmittelbar angrenzend angeordnet und ausgesetzt.

In einem zweiten Ausführungsbeispiel wird das metallische Substrat 2 für die Bipolarplatte 1 zunächst mit einer ersten Unterlagenschicht 4a in Form einer metallischen Legierungsschicht in einer Dicke von 100 nm beschichtet, wobei die metallische Legierungsschicht die Zusammensetzung Ti_{0,67} Nb_{0,33} aufweist. Anschließend erfolgt eine weitere Auftragung einer zweiten Unterlagenschicht 4b mit einer Dicke von 400nm der Zusammensetzung (Ti_{0,67} Nb_{0,33})₁₋ₓ Nₓ mit x=0,40 - 0,55. Darauf wird eine Deckschicht 3a in der Dicke von 10 nm in der Zusammensetzung Iridium-Kohlenstoff aufgetragen.

Der Vorteil ist eine außergewöhnlich hohe Stabilität gegen Oxidation der erfindungsgemäßen Bipolarplatte 1. Selbst bei einer dauerhaften Belastung von +3000 mV gegenüber einer Normalwasserstoffelektrode wird in schwefelsaurer Lösung, welche einen pH-Wert von 3 aufweist, keine Widerstandserhöhung festgestellt. Äußerlich bleibt die freie Oberfläche 30 der Deckschicht 3a, somit die vom Substrat 2 abgewandt ausgebildete Fläche der Deckschicht 3a, selbst nach 50h Dauerbelastung bei +2000 mV im Vergleich zu einer Normalwasserstoffelektrode, silberglänzend. Selbst in einer Rasterelektronenmikroskop-Untersuchung sind keine sich durch die Dicke der Deckschicht 3a zum Substrat 2 hin erstreckenden oder das Substrat 2 erreichende Korrosionsspuren erkennbar.

Die erfindungsgemäße Deckschicht 3a des zweiten Ausführungsbeispiels ist sowohl mittels der vakuumbasierten PVD-Sputtertechnik als auch mittels eines kathodischen ARC-Beschichtungsverfahren, auch Vakuumlichtbogenverdampfen genannt, applizierbar. Trotz einer höheren Dropletsanzahl, mit anderen Worten, einer im Vergleich zur Sputtertechnologie gesteigerten Metalltröpfchenanzahl, weist auch die im kathodischen ARC-Verfahren hergestellte erfindungsgemäße Deckschicht 3a die vorteilhaften Eigenschaften hoher Korrosionsbeständigkeit bei zeitstabiler Oberflächenleitfähigkeit, der mittels der Sputtertechnik hergestellten erfindungsgemäßen Deckschicht 3a auf.

In einem dritten Ausführungsbeispiel ist das erfindungsgemäße Schichtsystem 3 auf einem Substrat 2 in Form eines strukturierten Edelstahllochblechs ausgebildet. Das Substrat 2 ist vor einer Auftragung eines Schichtsystems 3 in einem H₂SO₄/H₃PO₄-Bad elektrolytisch poliert worden. Nach Aufbringung einer einzelnen Unterlagenschicht in Form einer mehrere 1000 nm dicken Tantalcarbidschicht wird eine Deckschicht 3a in Form einer mehrere 100 nm dicken Iridium-Kohlenstoff-Schicht aufgebracht.

Der Vorteil der aus dem Tantalcarbid ausgebildeten Unterlagenschicht besteht nicht nur in ihrer außerordentlichen Korrosionsbeständigkeit sondern auch darin, dass sie keinen Wasserstoff aufnimmt und dem Substrat 2 somit als Wasserstoffbarriere dient. Dieses ist insbesondere von Vorteil, sofern Titan als Substratmaterial verwendet wird.

Das erfindungsgemäße Schichtsystem 3 des dritten Ausführungsbeispiels ist geeignet für einen Einsatz einer Elektrolysezelle zur Erzeugung von Wasserstoff bei Stromdichten i, die größer als 500 mA cm⁻² sind.

Der Vorteil der im Schichtsystem zwischenliegenden und/oder beidseitig geschlossenen Metalloidschicht bzw. der zweiten Unterlagenschicht, die im einfachsten Fall beispielsweise aus Titannitrid gebildet ist, ist ihr niedriger elektrischer Widerstand von 10-12 mΩ cm⁻². Ebenso kann die erfindungsgemäße Beschichtung bzw. Deckschicht unter möglicher Widerstandserhöhung auch ohne eine zweite Unterlagenschicht bzw. Metalloidschicht ausgebildet sein.

In Tabelle 1 sind beispielhaft einige Schichtsysteme mit ihren charakteristischen Werten dargestellt.

**Tabelle 1: Schichten und ausgewählte charakteristische Werte**

| | Schichtsystem / Schichtdicke | Spezifischer Oberflächenwiderstand in mΩ cm⁻² bei T = 20° C | Korrosionsstrom bei -2000 mV Standardwasserstoffsäule in µA cm⁻² in wässriger schwefelsaurer Lösung (pH=3) bei T=80°C | Oxidationsstabilität bei 2000 mV gemessen als Veränderung des Oberflächenwidetstandes in mΩ cm⁻² |
|---|---|---|---|---|
| | | | | Zielwert: < 20 mΩ cm⁻² |
| 1 | Gold / 3 µm (als Referenz) | 9 | > 100 Pittingstrom | 9 -10 |
| 2 | Ti / 0,5 µm TiN / 1 µm Ir_{0.99} - C_{0,01} / 10nm | 8 | 0,001 | 12 |
| 3 | Ti_{0.67} Nb_{0.33} / 0,1 µm (Ti_{0,67} Nb_{0,33})₁₋ₓ Nₓ mit x= 0,40 - 0,55 / 0,4 µm Ir_{0,99} - C_{0,01} / 10nm | 7-8 | 0,01 | 1-2 |
| 4 | Zr / 0,5 µm ZrN / 1 µm Ir_{0,99} - C_{0,01} / 10 nm | 11 | 0,001 | 11-12 |
| 5 | Ta / 0,05 µm TaC / 0,5 µm Ir_{0,991}- C_{0,009} / 5 nm | 10 | 0,001 | 17-18 |
| 6 | ZrB₂ / 0,3 µm Ir_{0,7} - B_{0,3}/ 5 nm | 7 | Pittingreaktion nach 4h Belastung | |

In Tabelle 1 sind nur einige exemplarische Schichtsysteme dargestellt. Vorteilhafterweise weisen die erfindungsgemäßen Schichtsysteme bei einer anodischen Belastung von +2000 mV gegenüber Normalwasserstoffsäule in schwefelsaurer Lösung bei einer Temperatur mit einem Wert von 80 °C über mehrere Wochen keine Widerstandserhöhung auf. Die im Hochvakuum mittels eines Sputter- oder ARC-Verfahrens oder im Feinvakuum mittels PECVD-Verfahren (Plasmaunterstütztes chemisches Gasphasenabscheideverfahren) oder in einem ALD-Verfahren (Atomic Layer Deposition) aufgebrachten Schichtsysteme waren nach dieser Belastungszeit teilweise dunkel verfärbt. Allerdings traten keine sichtbaren Korrosionserscheinungen oder signifikante Veränderungen der Oberflächenwiderstände auf.

### Bezugszeichenliste

- 1: Bipolarplatte
- 2: Substrat
- 3: Schichtsystem
- 3a: Deckschicht
- 4: Unterlagenschichtsystem
- 4a: erste Unterlagenschicht
- 4b: zweite Unterlagenschicht
- 30: freie Oberfläche

## Patentansprüche

1. Beschichtung (3a), insbesondere für eine Bipolarplatte (1) einer Brennstoffzelle oder eines Elektrolyseurs, wobei die Beschichtung (3a) aus einer homogenen oder heterogenen festen metallischen Lösung besteht, die entweder ein erstes chemisches Element aus der Gruppe der Edelmetalle in Form von Iridium in einer Konzentration von mindestens 99 At.-% enthält oder
ein erstes chemisches Element aus der Gruppe der Edelmetalle in Form von Iridium und ein zweites chemisches Element aus der Gruppe der Edelmetalle in Form von Ruthenium enthält, wobei das erste chemische Element und das zweite chemische Element insgesamt in einer Konzentration von mindestens 99 At.-% vorhanden sind, sowie weiterhin zumindest ein nichtmetallisches chemisches Element enthält aus der Gruppe umfassend Stickstoff, Kohlenstoff, Fluor, wobei das mindestens eine nichtmetallische chemische Element in einer Konzentration im Bereich von 0,1 bis 1 At.-% in der Schicht vorhanden ist und wobei weiterhin Sauerstoff und Wasserstoff lediglich in Spuren vorhanden sind.

2. Beschichtung nach Anspruch 1, **dadurch gekennzeichnet, dass** diese
a) mindestens 99 At.-% Iridium und weiterhin Kohlenstoff und in Spuren Sauerstoff und Wasserstoff umfasst; oder
b) mindestens 99 At.-% Iridium und weiterhin Kohlenstoff und Fluor, sowie in Spuren Sauerstoff und Wasserstoff, umfasst; oder
c) in Summe mindestens 15 bis 98,9 At.-% Iridium und 0,1 bis 84 At.-% Ruthenium und weiterhin Kohlenstoff und in Spuren Sauerstoff und Wasserstoff umfasst; oder
d) in Summe mindestens 15 bis 98,9 At.-% Iridium und 0,1 bis 84 At.-% Ruthenium und weiterhin Kohlenstoff und Fluor, sowie weiterhin in Spuren Sauerstof und Wasserstoff, umfasst.

3. Beschichtung nach Anspruch 2, **dadurch gekennzeichnet, dass** diese Iridium in einer Konzentration von mindestens 99 At.-% und Kohlenstoff in einer Konzentration im Bereich von 0,1 bis kleiner 1 At.-% umfasst, oder
dass diese Iridium in einer Konzentration von mindestens 99 At.-% und Stickstoff in einer Konzentration im Bereich von 0,1 bis kleiner 1 At.-% umfasst, oder
dass diese Iridium in einer Konzentration im Bereich von 15 bis 98,9 At.-%, Ruthenium in einer Konzentration im Bereich von 0,1 bis 84 At.-% und Kohlenstoff in einer Konzentration im Bereich von 0,1 bis kleiner 1 At.-% umfasst, oder
dass diese Iridium in einer Konzentration im Bereich von 15 bis 98,9 At.-%, Ruthenium in einer Konzentration im Bereich von 0,1 bis 84 At.-% und Stickstoff in einer Konzentration im Bereich von 0,1 bis kleiner 1 At.-% umfasst.

4. Beschichtung nach einem der vorherigen Ansprüche, **dadurch gekennzeichnet, dass** diese Fluor in einer Konzentration bis maximal 0,5 At.-% umfasst.

5. Beschichtung nach einem der vorherigen Ansprüche, **dadurch gekennzeichnet, dass** die Beschichtung (3a) weiterhin mindestens ein chemisches Element aus der Gruppe der unedlen Metalle enthält.

6. Beschichtung nach Anspruch 6, **dadurch gekennzeichnet, dass** das mindestens eine chemische Element aus der Gruppe der unedlen Metalle Aluminium, Eisen, Nickel, Kobalt, Zink, Cer oder Zinn ist.

7. Beschichtung nach Anspruch 6 oder 7, **dadurch gekennzeichnet, dass** das mindestens eine weitere chemische Element aus der Gruppe der unedlen Metalle im Konzentrationsbereich von 0,005 bis 0,01 At.-% in der Schicht enthalten ist.

8. Beschichtung nach einem der vorherigen Ansprüche, **dadurch gekennzeichnet, dass** die Beschichtung (3a) weiterhin zumindest ein chemisches Element aus der Gruppe der Refraktärmetalle aufweist.

9. Beschichtung nach Anspruch 8, **dadurch gekennzeichnet, dass** die Beschichtung (3a) zumindest ein chemisches Element aus der Gruppe der Refraktärmetalle in Form von Titan und/oder Zirkonium und/oder Hafnium und/oder Niob und/oder Tantal aufweist.

10. Beschichtung nach Anspruch 8 oder 9, **dadurch gekennzeichnet, dass** das mindestens eine chemische Element aus der Gruppe der Refraktärmetalle im Konzentrationsbereich von 0,005 bis 0,01 At.-% in der Beschichtung (3a) enthalten ist.

11. Beschichtung nach den Ansprüchen 5 bis 10, **dadurch gekennzeichnet, dass** das mindestens eine chemische Element aus der Gruppe der unedlen Metalle in Form von Zinn und das mindestens eine chemische Element aus der Gruppe der Refraktärmetalle zusammen im Konzentrationsbereich von 0,01 bis 0,02 At.-%, in der Beschichtung (3a) enthalten sind.

12. Beschichtung nach einem der vorherigen Ansprüche, **dadurch gekennzeichnet, dass** die Beschichtung (3a) weiterhin mindestens ein zusätzliches chemisches Element aus der Gruppe der Edelmetalle in einem Konzentrationsbereich von 0,005 bis 0,9 At.-% aufweist.

13. Beschichtung nach Anspruch 12, **dadurch gekennzeichnet, dass** das chemische Element aus der Gruppe der Edelmetalle Platin, Gold, Silber, Rhodium, Palladium ist.

14. Beschichtung nach einem der vorherigen Ansprüche, **dadurch gekennzeichnet, dass** alle chemischen Elemente aus der Gruppe der Edelmetalle, inklusive Iridium und Ruthenium, im Konzentrationsbereich von 99 bis 99,9 At.-% in der Beschichtung enthalten sind.

15. Beschichtung nach einem der vorherigen Ansprüche, **dadurch gekennzeichnet, dass** die Beschichtung (3a) eine Schichtdicke von mindestens 1 nm bis maximal 50 nm aufweist.

16. Schichtsystem (3), insbesondere für eine Bipolarplatte (1) einer Brennstoffzelle oder eines Elektrolyseurs, umfassend eine Deckschicht (3a) und ein Unterlagenschichtsystem (4), **dadurch gekennzeichnet, dass** die Deckschicht (3a) in Form einer Beschichtung (3a) nach den Ansprüchen 1 bis 15 ausgebildet ist.

17. Schichtsystem nach Anspruch 16, **dadurch gekennzeichnet, dass** das Unterlagenschichtsystem (4) mindestens eine Unterlagenschicht (4a, 4b) aufweist umfassend mindestens ein chemisches Element aus der Gruppe Titan, Niob, Hafnium, Zirkonium, Tantal.

18. Schichtsystem nach Anspruch 17, **dadurch gekennzeichnet, dass** das Unterlagenschichtsystem (4) mindestens eine erste Unterlagenschicht (4a) in Form einer metallischen Legierungsschicht umfassend die chemischen Elemente Titan und Niob aufweist.

19. Schichtsystem nach Anspruch 17 oder 18, **dadurch gekennzeichnet, dass** das Unterlagenschichtsystem (4) eine zweite Unterlagenschicht (4b) aufweist umfassend mindestens ein chemisches Element aus der Gruppe Titan, Niob, Hafnium, Zirkonium, Tantal und weiterhin mindestens ein nichtmetallisches Element aus der Gruppe Stickstoff, Kohlenstoff, Bor, Fluor.

20. Schichtsystem nach Anspruch 19, **dadurch gekennzeichnet, dass** die zweite Unterlagenschicht (4b) zwischen der ersten Unterlagenschicht (4a) und der Deckschicht (3a) angeordnet ist.

21. Schichtsystem nach Anspruch 19 oder 20, **dadurch gekennzeichnet, dass** die zweite Unterlagenschicht (4b) bis zu 5 At.-% Sauerstoff enthält.

22. Bipolarplatte (1) umfassend ein metallisches Substrat (2) und ein zumindest in Teilbereichen der Oberfläche des Substrats (2) aufgebrachtes Schichtsystem (3) nach einem der Ansprüche 16 bis 21.

23. Brennstoffzelle, insbesondere Polymerelektrolytbrennstoffzelle, umfassend mindestens eine Bipolarplatte (1) nach Anspruch 22.

24. Elektrolyseur, umfassend mindestens eine Bipolarplatte (1) nach Anspruch 22.

## Claims

1. A coating (3a), in particular for a bipolar plate (1) of a fuel cell or an electrolyser, wherein the coating (3a) consists of a homogeneous or heterogeneous solid metallic solution, which either contains a first chemical element from the group of noble metals in the form of iridium at a concentration of at least 99 at% or
contains a first chemical element from the group of noble metals in the form of iridium and a second chemical element from the group of noble metals in the form of ruthenium, wherein the first chemical element and the second chemical element are present in total in a concentration of at least 99 at%, and further contains at least one non-metallic chemical element from the group comprising nitrogen, carbon and fluorine, wherein the at least one non-metallic chemical element is present in the layer in a concentration in the range from 0.1 to 1 at% and wherein, furthermore, oxygen and hydrogen are only present in traces.

2. The coating according to claim 1, **characterised in that** it comprises
a) at least 99 at% iridium and, furthermore, carbon and traces of oxygen and hydrogen; or
b) at least 99 at% iridium and, furthermore, carbon and fluorine, as well as traces of oxygen and hydrogen; or
c) in total at least 15 to 98.9 at% iridium and 0.1 to 84 at% ruthenium and, furthermore, carbon and traces of oxygen and hydrogen; or
d) in total at least 15 to 98.9 at% iridium and 0.1 to 84 at% ruthenium and, furthermore, carbon and fluorine, as well as traces of oxygen and hydrogen.

3. The coating according to claim 2, **characterised in that** it comprises iridium in a concentration of at least 99 at% and carbon in a concentration in the range from 0.1 to less than 1 at%, or
**in that** it comprises iridium in a concentration of at least 99 at% and nitrogen in a concentration in the range from 0.1 to less than 1 at%, or **in that** it comprises iridium in a concentration in the range from 15 to 98.9 at%, ruthenium in a concentration in the range from 0.1 to 84 at% and carbon in a concentration in the range from 0.1 to less than 1 at%, or **in that** it comprises iridium in a concentration in the range from 15 to 98.9 at%, ruthenium in a concentration in the range from 0.1 to 84 at% and nitrogen in a concentration in the range from 0.1 to less than 1 at%.

4. The coating according to any one of the preceding claims, **characterised in that** it comprises fluorine in a concentration of up to a maximum of 0.5 at%.

5. The coating according to any one of the preceding claims, **characterised in that** the coating (3a) further contains at least one chemical element from the group of base metals.

6. The coating according to claim 6, **characterised in that** the at least one chemical element from the group of base metals is aluminium, iron, nickel, cobalt, zinc, cerium or tin.

7. The coating according to claim 6 or 7, **characterised in that** the at least one further chemical element from the group of base metals is contained in the layer in the concentration range from 0.005 to 0.01 at%.

8. The coating according to any one of the preceding claims, **characterised in that** the coating (3a) furthermore has at least one chemical element from the group of refractory metals.

9. The coating according to claim 8, **characterised in that** the coating (3a) has at least one chemical element from the group of refractory metals in the form of titanium and/or zirconium and/or hafnium and/or niobium and/or tantalum.

10. The coating according to claim 8 or 9, **characterised in that** the at least one chemical element from the group of refractory metals is contained in the coating (3a) in the concentration range from 0.005 to 0.01 at%.

11. The coating according to claims 5 to 10, **characterised in that** the at least one chemical element from the group of base metals in the form of tin and the at least one chemical element from the group of refractory metals are contained in the coating (3a) together in the concentration range from 0.01 to 0.02 at%.

12. The coating according to any one of the preceding claims, **characterised in that** the coating (3a) furthermore has at least one additional chemical element from the group of noble metals in a concentration range from 0.005 to 0.9 at%.

13. The coating according to claim 12, **characterised in that** the chemical element from the group of noble metals is platinum, gold, silver, rhodium or palladium.

14. The coating according to any one of the preceding claims, **characterised in that** all chemical elements from the group of noble metals, including iridium and ruthenium, are contained in the coating in the concentration range from 99 to 99.9 at%.

15. The coating according to any one of the preceding claims, **characterised in that** the coating (3a) has a layer thickness from at least 1 nm to a maximum of 50 nm.

16. A layer system (3), in particular for a bipolar plate (1) of a fuel cell or an electrolyser, comprising a cover layer (3a) and a base layer system (4), **characterised in that** the cover layer (3a) is designed in the form of a coating (3a) according to claims 1 to 15.

17. The layer system according to claim 16, **characterised in that** the base layer system (4) has at least one base layer (4a, 4b) comprising at least one chemical element from the group consisting of titanium, niobium, hafnium, zirconium and tantalum.

18. The layer system according to claim 17, **characterised in that** the base layer system (4) has at least one first base layer (4a) in the form of a metallic alloy layer comprising the chemical elements titanium and niobium.

19. The layer system according to claim 17 or 18, **characterised in that** the base layer system (4) has a second base layer (4b) comprising at least one chemical element from the group consisting of titanium, niobium, hafnium, zirconium and tantalum, and furthermore at least one non-metallic element from the group consisting of nitrogen, carbon, boron and fluorine.

20. The layer system according to claim 19, **characterised in that** the second base layer (4b) is arranged between the first base layer (4a) and the cover layer (3a).

21. The layer system according to claim 19 or 20, **characterised in that** the second base layer (4b) contains up to 5 at% oxygen.

22. A bipolar plate (1) comprising a metallic substrate (2) and a layer system (3) according to any one of claims 16 to 21 applied at least in subregions of the surface of the substrate (2).

23. A fuel cell, in particular a polymer electrolyte fuel cell, comprising at least one bipolar plate (1) according to claim 22.

24. An electrolyser comprising at least one bipolar plate (1) according to claim 22.

## Revendications

1. Revêtement (3a), en particulier pour une plaque bipolaire (1) d'une pile à combustible ou d'un électrolyseur, le revêtement (3a) consistant en une solution métallique solide homogène ou hétérogène qui contient soit un premier élément chimique du groupe des métaux nobles sous forme d'iridium à une concentration en pourcentage atomique d'au moins 99 % soit
qui contient un premier élément chimique du groupe des métaux nobles sous forme d'iridium et un second élément chimique du groupe des métaux nobles sous forme de ruthénium, le premier élément chimique et le second élément chimique étant au total présents à une concentration en pourcentage atomique d'au moins 99 % et contient en outre au moins un élément chimique non métallique du groupe comprenant l'azote, le carbone, le fluor, l'au moins un élément chimique non métallique étant présent dans la couche à une concentration en pourcentage atomique située dans la plage de 0,1 à 1 %, par ailleurs l'oxygène et l'hydrogène n'étant présents qu'à l'état de traces.

2. Revêtement selon la revendication 1, **caractérisé en ce que**
a) celui-ci comprend un pourcentage atomique d'au moins 99 % d'iridium et en outre du carbone et des traces d'oxygène et d'hydrogène ; ou
b) comprend un pourcentage atomique d'au moins 99 % d'iridium et en outre du carbone et du fluor, ainsi que des traces d'oxygène et d'hydrogène ; ou
c) comprend au total un pourcentage atomique d'au moins 15 à 98,9 % d'iridium et de 0,1 à 84 % de ruthénium et en outre du carbone et des traces d'oxygène et d'hydrogène ; ou
d) comprend au total un pourcentage atomique d'au moins 15 à 98,9 % d'iridium et de 0,1 à 84 % de ruthénium et en outre du carbone et du fluor, ainsi que des traces d'oxygène et d'hydrogène.

3. Revêtement selon la revendication 2, **caractérisé en ce que** celui-ci comprend de l'iridium à une concentration en pourcentage atomique d'au moins 99 % et du carbone à une concentration en pourcentage atomique située dans la plage de 0,1 à moins de 1 % ou
**en ce que** celui-ci comprend de l'iridium à une concentration en pourcentage atomique d'au moins 99 % et de l'azote à une concentration en pourcentage atomique située dans la plage de 0,1 à moins de 1 % ou **en ce que** celui-ci comprend de l'iridium à une concentration en pourcentage atomique située dans la plage de 15 à 98,9 %, du ruthénium à une concentration en pourcentage atomique située dans la plage de 0,1 à 84 % et du carbone à une concentration en pourcentage atomique située dans la plage de 0,1 à moins de 1 % ou **en ce que** celui-ci comprend de l'iridium à une concentration en pourcentage atomique située dans la plage de 15 à 98,9 %, du ruthénium à une concentration en pourcentage atomique située dans la plage de 0,1 à 84 % et de l'azote à une concentration en pourcentage atomique située dans la plage de 0,1 à moins de 1 %.

4. Revêtement selon l'une quelconque des revendications précédentes, **caractérisé en ce que** celui-ci comprend du fluor à une concentration en pourcentage atomique jusqu'à un maximum de 0,5 %.

5. Revêtement selon l'une quelconque des revendications précédentes, **caractérisé en ce que** le revêtement (3a) contient en outre au moins un élément chimique du groupe des métaux communs.

6. Revêtement selon la revendication 6, **caractérisé en ce que** l'au moins un élément chimique du groupe des métaux communs est l'aluminium, le fer, le nickel, le cobalt, le zinc, le cérium ou l'étain.

7. Revêtement selon la revendication 6 ou 7, **caractérisé en ce que** l'au moins un autre élément chimique du groupe des métaux communs est contenu dans la couche dans la plage de concentration en pourcentage atomique de 0,005 à 0,01 %.

8. Revêtement selon l'une quelconque des revendications précédentes, **caractérisé en ce que** le revêtement (3a) comporte en outre au moins un élément chimique du groupe des métaux réfractaires.

9. Revêtement selon la revendication 8, **caractérisé en ce que** le revêtement (3a) comporte au moins un élément chimique du groupe des métaux réfractaires sous forme de titane et/ou de zirconium et/ou d'hafnium et/ou de niobium et/ou de tantale.

10. Revêtement selon la revendication 8 ou 9, **caractérisé en ce que** l'au moins un élément chimique du groupe des métaux réfractaires est contenu dans le revêtement (3a) dans la plage de concentration en pourcentage atomique de 0,005 à 0,01 %.

11. Revêtement selon les revendications 5 à 10, **caractérisé en ce que** l'au moins un élément chimique du groupe des métaux communs sous forme d'étain et l'au moins un élément chimique du groupe des métaux réfractaires sont contenus ensemble dans le revêtement (3a) dans la plage de concentration en pourcentage atomique de 0,01 à 0,02 %.

12. Revêtement selon l'une quelconque des revendications précédentes, **caractérisé en ce que** le revêtement (3a) comporte en outre au moins un élément chimique supplémentaire du groupe des métaux nobles dans une plage de concentration en pourcentage atomique de 0,005 à 0,9 %.

13. Revêtement selon la revendication 12, **caractérisé en ce que** l'élément chimique du groupe des métaux nobles est le platine, l'or, l'argent, le rhodium, le palladium.

14. Revêtement selon l'une quelconque des revendications précédentes, **caractérisé en ce que** tous les éléments chimiques du groupe des métaux nobles, y compris l'iridium et le ruthénium, sont contenus dans le revêtement dans la plage de concentration en pourcentage atomique de 99 à 99,9 %.

15. Revêtement selon l'une quelconque des revendications précédentes, **caractérisé en ce que** le revêtement (3a) présente une épaisseur de couche d'au moins 1 nm à un maximum de 50 nm.

16. Système de couches (3), en particulier pour une plaque bipolaire (1) d'une pile à combustible ou d'un électrolyseur, comprenant une couche de recouvrement (3a) et un système de sous-couches (4), **caractérisé en ce que** la couche de recouvrement (3a) est conçue sous la forme d'un revêtement (3a) selon les revendications 1 à 15.

17. Système de couches selon la revendication 16, **caractérisé en ce que** le système de sous-couches (4) comporte au moins une sous-couche (4a, 4b) comprenant au moins un élément chimique du groupe constitué par le titane, le niobium, l'hafnium, le zirconium, le tantale.

18. Système de couches selon la revendication 17, **caractérisé en ce que** le système de sous-couches (4) présente au moins une première sous-couche (4a) sous la forme d'une couche d'alliage métallique comprenant les éléments chimiques titane et niobium.

19. Système de couches selon la revendication 17 ou 18, **caractérisé en ce que** le système de sous-couches (4) comporte une seconde sous-couche (4b) comprenant au moins un élément chimique du groupe constitué par le titane, le niobium, l'hafnium, le zirconium, le tantale et en outre au moins un élément non métallique du groupe constitué par l'azote, le carbone, le bore, le fluor.

20. Système de couches selon la revendication 19, **caractérisé en ce que** la seconde sous-couche (4b) est disposée entre la première sous-couche (4a) et la couche de recouvrement (3a).

21. Système de couches selon la revendication 19 ou 20, **caractérisé en ce que** la seconde sous-couche (4b) contient jusqu'à 5 % d'oxygène en pourcentage atomique.

22. Plaque bipolaire (1) comprenant un substrat métallique (2) et un système de couches (3) selon l'une quelconque des revendications 16 à 21 appliqué au moins par endroits sur la surface du substrat (2).

23. Pile à combustible, en particulier pile à combustible à électrolyte polymère, comprenant au moins une plaque bipolaire (1) selon la revendication 22.

24. Électrolyseur comprenant au moins une plaque bipolaire (1) selon la revendication 22.
